Europäisches Patentamt

European Patent Office

Office européen des brevets

(19)

(11) **EP 0 731 565 B1**

(12) **EUROPEAN PATENT SPECIFICATION**

(45) Date of publication and mention
of the grant of the patent:
**20.12.2000 Bulletin 2000/51**

(51) Int Cl.[7]: **H03L 7/107**, H03L 7/099

(21) Application number: **95830082.4**

(22) Date of filing: **07.03.1995**

(54) **Fully integratable PLL with low jitter**

Voll-Integrierbarer Phasenregelkreis mit geringem Jitter

Boucle à verrouillage de phase entièrement intégrable et à faible gigue

(84) Designated Contracting States:
**DE FR GB IT**

(43) Date of publication of application:
**11.09.1996 Bulletin 1996/37**

(73) Proprietor: **STMicroelectronics S.r.l.**
**20041 Agrate Brianza (Milano) (IT)**

(72) Inventors:
• **Bruccoleri, Melchiorre**
**I-16132 Genova (IT)**
• **Vai, Gianfranco**
**I-27100 Pavia (IT)**
• **Portaluri, Salvatore**
**I-27100 Pavia (IT)**
• **Demicheli, Marco**
**I-22070 Binago (IT)**

(74) Representative: **Pellegri, Alberto et al**
**c/o Società Italiana Brevetti S.p.A.**
**Piazza Repubblica, 5**
**21100 Varese (IT)**

(56) References cited:
**EP-A- 0 595 632**      **US-A- 5 319 320**
**US-A- 5 369 376**

• **PROCEEDINGS OF THE IEEE 1992 CUSTOM INTEGRATED CIRCUITS CONFERENCE, 3 May 1992 BOSTON, pages 24.2.1-24.2.5, XP 000340948 REZA SHARIATDOUST ET AL. 'A Low Jitter 5 MHz to 180 MHz Clock Synthesizer for Video Graphics'**

## Description

The present invention relates to a fully integrated phase locked loop (PLL) particularly suited for applications that require a reduced short term stability (low jitter).

The invention is particularly useful for generating a programmable reference frequency in order to maintain constant the density of data stored on a support in a so-called read/write "channel" for hard disks or for implementing a phase separation of data (data separator PLL), and the like.

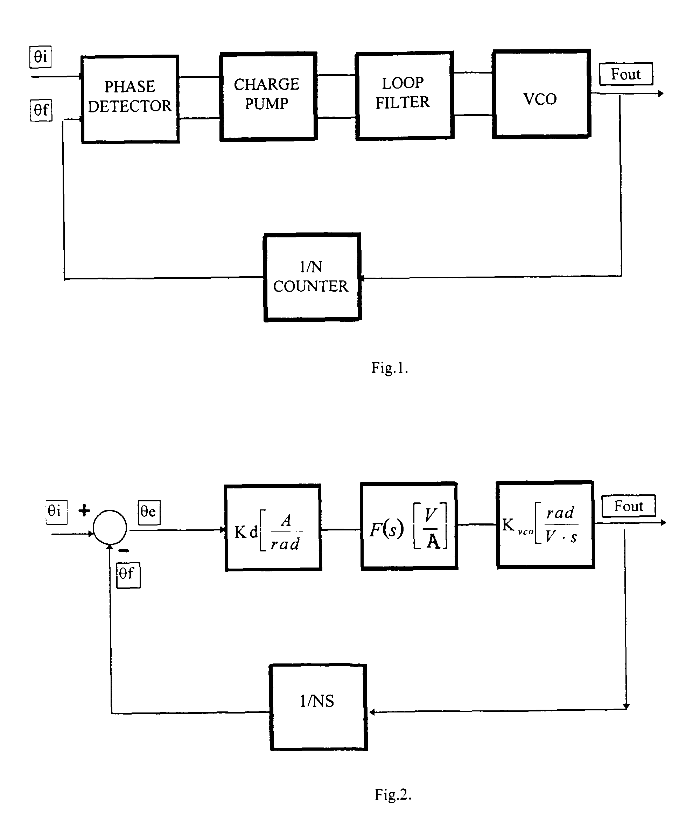

The functional block diagram of a phase locked loop (PLL) is depicted in Fig. 1.

Basically, the circuit comprises phase detecting means (PHASE DETECTOR) for monitoring the phase difference between two signals, a charge pump circuit: (CHARGE PUMP), a low pass filter (LOOP FILTER), a voltage controlled oscillator (VCO) and a phase control feedback network (1/N COUNTER).

An analysis of the frequency characteristic of the PLL may be based on a corresponding linear block diagram depicted in Fig. 2.

In the above mentioned applications, the transfer function F(s) of the low pass (loop) filter is commonly of the following type:

$$F(s) = \frac{1 + sCR}{s(C_1 + C + sCC_1R)}$$

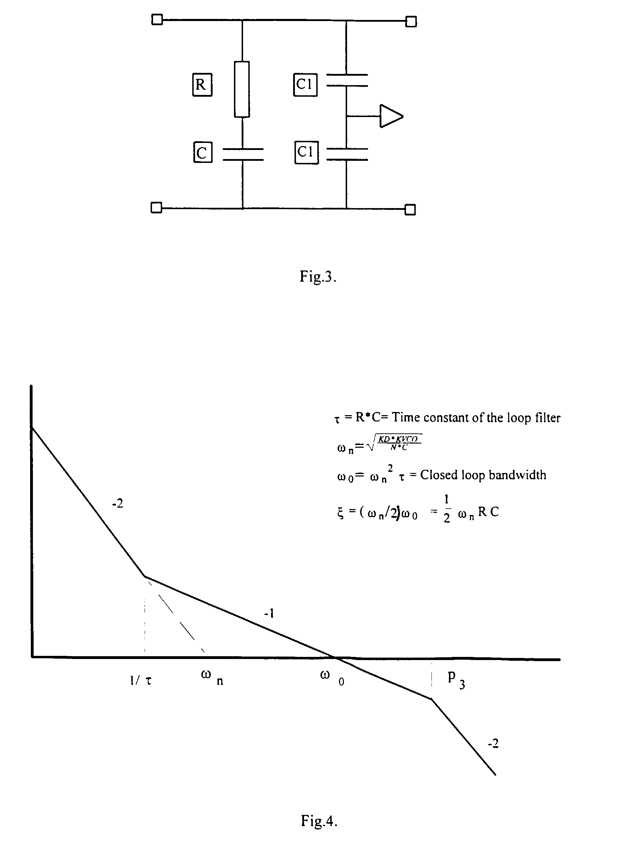

corresponding to the transfer function of a passive network as that shown in Fig. 3, which is often realized outside the integrated circuit.

The capacitances C1, functionally connected between the two nodes of the low pass filter and a common ground node of the circuit introduce a third pole in the transfer function of the PLL.

By an appropriate sizing, for example $C \approx 10C_1$, the transfer function of the low pass loop filter may be simplified as follows:

$$F(s) = \frac{1 + sCR}{sC}$$

By taking into account the above simplified expression, the open loop transfer function of the whole PLL may be written as follows:

$$H(s) = \frac{\theta_{out}}{\theta_{in}} = \frac{k_d \cdot k_{VCO}}{N \cdot C} \frac{(1 + sCR)}{s^2}$$

The open loop gain characteristic of the PLL, from which stability and ability to respond to eventual phase errors may be analyzed, is shown in Fig. 4. The presence of the third pole $p_3$ generated by the capacitances C1 is clearly recognizable in the diagram of Fig. 4.

As may be observed from the diagram of Fig. 4, the position of the zero $1/\tau$ and of the third pole $p_3$ markedly condition the functioning of the PLL system.

US-5,369,376 discloses a third order PLL whereby a tunable capacitance C2 introducing the third pole of the PLL transfer function is included in series with a second capacitance C1 within the low pass filter (loop filter) of the PLL. This second capacitance is variable and is controlled together with the time constant of the loop filter to independently control phase margin and bandwith.

The article entitled "A Low Jitter 5 MHz to 180 MHz Clock Synthesizer for Video Graphics", by Reza Shariatdoust, et al. Proceedings of the IEEE 1992 Custon Integrated Circuits Conference, 3 May 1992, Boston, describes a second order PLL circuit wherein a tunable resistance is employed in lieu of a tunable capacitance $C_1$ in the V/I converter stage of the VCO.

On the other hand, especially for the type of application mentioned above, $\omega_o$ should be adjustable while maintaining constant the damping factor $\xi$.

In order to satisfy these important requisites $1/\tau$ and $p_3$ should be sufficiently spaced from each other in the frequency domain in order to ensure a damping factor $\xi$ of sufficient value (typically not less than 0.707).

On the other hand, the position of the pole $p_3$ should not be <u>excessively distant</u> from $1/\tau$, because the loop must retain a good rejection capability of high frequency of disturbances, in order to optimize the short term stability characteristic (that is minimize to so-called jitter).

In known circuits, it is difficult to conciliate these contrasting requirements in an optimum way and generally these conditions imply a definite limitation in the ability of minimizing jitter. This is extremely critical when the capacitances are external to the chip because of the presence of disturbances coming from the supply rails on the metal frame on which the chip is mounted. On the other hand, even in known circuits made in a completely integrated form, the ability to appropriately filter high frequency disturbances remains limited.

It has now been found and represents the object of the present invention, a way to produce a third pole $p_3$ in the transfer function of a phase locked loop, that overcomes the limitations and drawbacks of the known circuits and markedly suppresses noise to the advantage of a further reduction of the jitter. This is achieved by the PLL according to Claim 1 and by the method according to Claim 3, i.e. by implementing an effective tracking between the $1/\tau$ zero and the third pole $p_3$ so as to make their separation in frequency domain practically insensitive to process spread, thus permitting the raising of the value of $\omega_o$ while maintaining constant the damping factor $\xi$.

Essentially the invention consists in creating a third pole $p_3$ by the use of a capacitance connected between the output of a voltage-to-current converting input stage of the VCO and a common ground node of the circuit and by controlling the value of the capacitance by the use of same digital/analog converter that is normally used for controlling the time constant $\tau$ of the low pass loop filter.

The different aspects and advantages of the invention will be more easily understood through the following description of an important embodiment, having a purely illustrative and nonlimitative purpose, and by referring to the annexed drawings, wherein:

Figure 1, as mentioned above, shows a typical block diagram of a PLL;

Figure 2, as mentioned above, represents a linear block diagram of a PLL;

Figure 3, as mentioned above, is the circuit diagram of a passive network implementing a low pass loop filter and producing a third pole $p_3$;

Figure 4, as mentioned above, shows the frequency response characteristic of the PLL;

Figure 5 is a partial block diagram of a fully integrated low pass loop filter;

Figure 6 shows a VCO circuit incorporating means for generating a third pole $p_3$ according to the present invention.

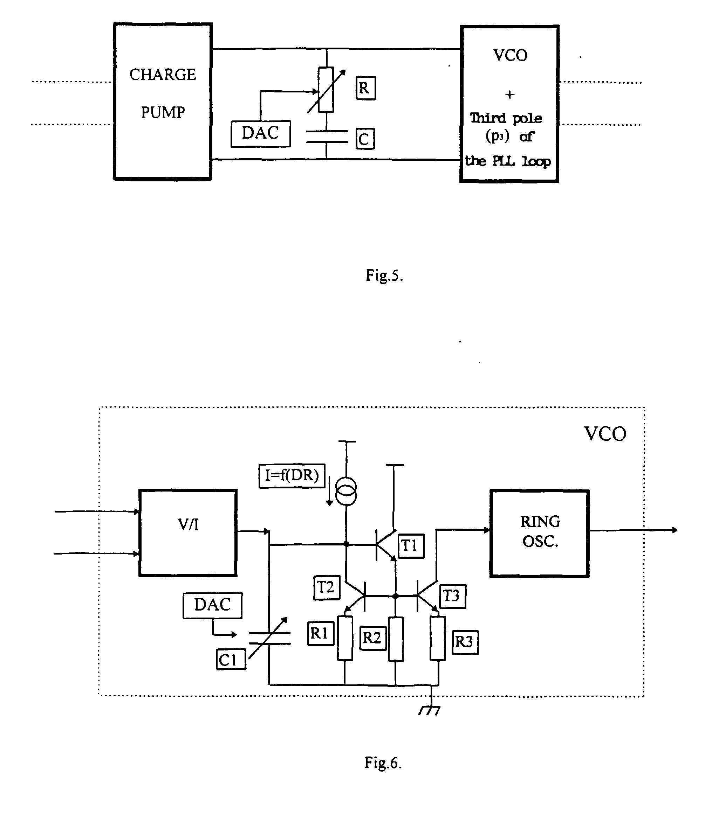

By referring to the schemes of Figures 5 and 6, according to the present invention, the third pole $p_3$ of the loop's transfer function is established by modifying the internal circuit of the VCO block which typically comprises an input voltage-to-current converting stage (V/I) followed by a common ring oscillator.

According to the invention, the third pole $p_3$ is generated by connecting a capacitance C1 between the output node of the voltage-to-current converting stage (V/I) of the VCO circuit and a common ground node of the circuit and controlling the value of the capacitance C1 by the use of the same digital/analog converter (DAC) which controls the time constant T of the low pass loop filter, which is functionally connected in cascade to the charge pump circuit.

By implementing the low pass filter of the PLL loop as well as the capacitance C1 in a fully integrated form, the noise that is injected into the loop is minimized with positive effects in keeping low the jitter.

By connecting the capacitance C1 to the output of the voltage-to-current (V/I) converting input stage of the VCO circuit, the noise is sensibly reduced because the capacitance C1 filters also disturbances coming from the V/I circuit and, in the depicted example, also from the supply rails through the current generator I=f(DR) which provides a regulation current drive of the VCO, thus further reducing the jitter.

By using the same digital/analog converter DAC for controlling the value of the capacitance C1 while regulating the time constant T of the low pass loop filter, the $\omega_o$ of the PLL may be increased while maintaining perfectly constant the damping factor $\xi$. In prac-

tice the DAC controls the frequency separation between the $1/\tau$ zero and the pole $p_3$, thus optimizing the performance of the PLL.

**Claims**

1. A fully integrated, phase locked loop (PLL) comprising a phase detector, a charge pump, a low pass filter a voltage controlled oscillator having a voltage-to-current converting input stage (V/I), connected in cascade, and a phase control feedback line, a digital/analog converter (DAC) controlling the time constant ($\tau$) of said low pass filter and capacitive means for generating a third pole (P3) in the transfer function of the PLL, characterized in that said capacitive means are constituted by a variable capacitance (C1) connected between the output node of said voltage-to-current converting input stage (V/I) of the voltage controlled oscillator (VCO) and a ground node of the circuit, the value of which is controlled by the same digital/analog converter (DAC) which controls the time constant of said low pass filter, keeping substantially constant the frequency separation of the zero of the transfer function determined by the reciprocal of time constant of the low pass filter ($1/\tau$) and of said third pole ($P_3$).

2. The phase locked loop (PLL) according the claim 1 and wherein the oscillator (VCO) is controlled by the sum of the output current of said voltage-to-current converting input stage (V/I) and a regulation current ($I=f(_{DR})$) and characterized by comprising a current mirror circuit (T1, T2, T3, R1, R2, R3) capable of forcing said sum current on a control node of said oscillator.

3. A method of generating a third pole ($p_3$) in a transfer function of a phase locked loop (PLL) comprising a charge pump circuit, a low pass loop filter whose time constant ($\tau$) is controlled by a digital/analog converter (DAC) and a voltage controlled oscillator (VCO) having a voltage-to-current converting input state (V/I) characterized by comprising

connecting a variable capacitance (C1) between the output of said voltage-to-current converting input stage (V/I) of said voltage controlled oscillator (VCO) and a common ground node of the circuit;
controlling the separation in the frequency domain between said third pole ($p_3$) and the zero ($1/\tau$) of the transfer function determined by the reciprocal of the time constant ($\tau$) of said low pass filter, by controlling the value of said capacitance by said digital/analog converter (DAC) which controls said time constant ($\tau$) of the low pass filter.

**Patentansprüche**

1. Vollständig integrierte Phasenverriegelungsschleife (PLL) mit einem Phasendetektor, einer Ladungspumpe, einem Tiefpaßfilter, einem spannungsgesteuerten Oszillator, der eine in Kaskade geschaltete Spannungs-/Strom-Umsetzungseingangsstufe (V/I) sowie eine Phasenregelungsrückkopplungsleitung enthält, einem Digital/Analog-Umsetzer (DAC), der die Zeitkonstante ($\tau$) des Tiefpaßfilters steuert, und kapazitiven Mitteln, die einen dritten Pol (P3) in der Übertragungsfunktion der PLL erzeugt, dadurch gekennzeichnet, daß die kapazitiven Mittel durch eine variable Kapazität (C1) gebildet sind, die zwischen den Ausgangsknoten der Spannungs-/Strom-Umsetzungseingangsstufe (V/I) des spannungsgesteuerten Oszillators (VCO) und einen Masseknoten der Schaltung geschaltet ist, wobei der Wert der variablen Kapazität (C1) die Zeitkonstante des Tiefpaßfilters steuert und die Frequenztrennung der Null der Übertragungsfunktion, die durch den Kehrwert der Zeitkonstante des Tiefpaßfilters ($1/\tau$) bestimmt ist, und des dritten Pols ($P_3$) im wesentlichen konstant hält.

2. Phasenverriegelungsschleife (PLL) nach Anspruch 1, wobei der Oszillator (VCO) durch die Summe aus dem Ausgangsstrom der Spannungs-/Strom-Umsetzungseingangsstufe (V/I) und aus dem Regulierungsstrom (I = f(DR)) gesteuert wird, gekennzeichnet durch

   eine Stromspiegelungsschaltung (T1, T2, T3, R1, R2, R3), die den Summenstrom zu einem Steuerknoten des Oszillators zwingen kann.

3. Verfahren zum Erzeugen eine dritten Pols ($p_3$) in einer Übertragungsfunktion einer Phasenverriegelungsschleife (PLL), die versehen ist mit einer Ladungspumpenschaltung, einem Tiefpaßschleifenfilter, dessen Zeitkonstante ($\tau$) durch einen Digital/Analog-Umsetzer (DAC) gesteuert wird, und einem spannungsgesteuerten Oszillator (VCO), der eine Spannungs-/Strom-Umsetzungseingangsstufe (V/I) enthält, gekennzeichnet durch

   Schalten einer variablen Kapazität (C1), zwischen den Ausgang der Spannungs-/Strom-Umsetzungseingangsstufe (V/I) des spannungsgesteuerten Oszillators (VCO) und einen gemeinsamen Masseknoten der Schaltung;
   Steuern der Trennung im Frequenzbereich zwischen dem dritten Pol ($p_3$) und der durch den Kehrwert der Zeitkonstante ($\tau$) des Tiefpaßfilters bestimmten Null ($1/\tau$) der Übertragungsfunktion durch Steuern des Wertes der Kapazität durch den Digital/Analog-Umsetzer (DAC), der die Zeitkonstante ($\tau$) des Tiefpaßfilters steuert.

**Revendications**

1. Boucle à verrouillage de phase (PPL) complètement intégrée comprenant un détecteur de phase, une pompe de charge, un filtre passe-bas, un oscillateur à commande en tension, comprenant un étage d'entrée de conversion tension/courant (V/I), connecté en cascade, et une ligne de réaction de commande de phase, un convertisseur numérique/analogique (DAC) commandant la constante de temps ($\tau$) du filtre passe-bas et un moyen capacitif pour générer un troisième pôle (P3) dans la fonction de transfert de la boucle à verrouillage de phase, caractérisée en ce que le moyen capacitif est constitué d'une capacité variable (C1) connectée entre le noeud de sortie de l'étage d'entrée de conversion tension/courant (V/I) de l'oscillateur à commande en tension (VCO) et un noeud de masse du circuit, dont la valeur est commandée par le même convertisseur numérique/analogique (DAC) qui commande la constante de temps du filtre passe-bas, en maintenant sensiblement constante la séparation en fréquence du zéro de la fonction de transfert déterminée par l'inverse de la constante de temps du filtre passe-bas ($1/\tau$) et du troisième pôle ($P_3$).

2. Boucle à verrouillage de phase (PLL) selon la revendication 1, dans laquelle l'oscillateur (VCO) est commandé par la somme du courant de sortie de l'étage d'entrée de conversion tension/courant (V/I) et d'un courant de régulation (I=f(DR)), et caractérisée en ce qu'elle comprend :

   un circuit miroir de courant (T1, T2, T3, R1, R2, R3) propre à forcer le courant somme sur un noeud de commande de l'oscillateur.

3. Procédé de génération d'un troisième pôle (P3) dans une fonction de transfert d'une boucle à verrouillage de phase (PLL) comprenant un circuit de pompe de charge, un filtre passe-bas dont la constante de temps ($\tau$) est commandée par un convertisseur numérique/analogique (DAC) et un oscillateur à commande en tension (VCO) ayant un étage d'entrée de conversion tension/courant (V/I), caractérisé en ce qu'il comprend les étapes suivantes :

   connecter une capacité variable (C1) entre la sortie de l'étage d'entrée de conversion tension/courant (V/I) de l'oscillateur à commande en tension (VCO) et un noeud de masse commun du circuit ;
   commander la séparation dans le domaine fréquentiel entre le troisième pôle (P3) et le zéro ($1/\tau$) de la fonction de transfert déterminée par l'inverse de la constante de temps ($\tau$) du filtre passe-bas, en commandant la valeur de la capacité par le convertisseur numérique/analogique (DAC) qui cade la constante de temps ($\tau$)

du filtre passe-bas.

Fig.1.

Fig.2.

Fig.3.

$\tau = R*C =$ Time constant of the loop filter

$\omega_n = \sqrt{\frac{KD*KVCO}{N*C}}$

$\omega_0 = \omega_n^2 \tau =$ Closed loop bandwidth

$\xi = (\omega_n/2)\omega_0 = \frac{1}{2}\omega_n R C$

Fig.4.

Fig.5.

Fig.6.